(19) Europäisches Patentamt

European Patent Office

Office européen des brevets

(11) Numéro de publication: **0 082 082**
**B1**

(12) **FASCICULE DE BREVET EUROPEEN**

(45) Date de publication du fascicule du brevet:
31.07.85

(51) Int. Cl.⁴: **G 01 R 15/02,** H 01 F 40/06,
**G 01 R 19/15**

(21) Numéro de dépôt: **82402279.2**

(22) Date de dépôt: **14.12.82**

(54) **Dispositif de mesure du courant qui circule dans un conducteur.**

(30) Priorité: **15.12.81 FR 8123379**

(43) Date de publication de la demande:
**22.06.83 Bulletin 83/25**

(45) Mention de la délivrance du brevet:
**31.07.85 Bulletin 85/31**

(84) Etats contractants désignés:
**AT BE CH DE GB IT LI NL SE**

(56) Documents cités:
**FR - A - 2 258 633**
**FR - A - 2 412 846**

(73) Titulaire: **LA TELEMECANIQUE ELECTRIQUE, 33 bis,**
**avenue du Maréchal Joffre, F-92000 Nanterre (FR)**

(72) Inventeur: **Souques, Georges, 5, Place de Rungis,**
**F-75013 Paris (FR)**
Inventeur: **Carlou, Roland, 65, Boulevard Hipolyte**
**Marquès, F-94200 Ivry (FR)**
Inventeur: **Coudron, Robert André, 16, Sentier des Hales,**
**F-92190 Meudon (FR)**
Inventeur: **Fechant, Louis, 19, rue Albert 1er, F-78110 Le**
**Vesinet (FR)**
Inventeur: **Le Guillerm, Jean, Avenue des Vignes**
**Benettes, F-78230 Le Pecq (FR)**

(74) Mandataire: **Marquer, Francis, CABINET**
**MOUTARD 35, avenue Victor Hugo Résidence**
**Champfleury, F-78180 Voisins le Bretonneux (FR)**

## Description

L'invention se rapporte aux dispositifs de mesure du courant qui circule dans un conducteur, en particulier dans des installations industrielles.

On connaît différents types de dispositifs appropriés à cet effet, par exemple les capteurs à effet Hall, dans lesquels l'induction engendrée par le courant à mesurer est appliquée à un barreau semi-conducteur, parcouru par un courant d'alimentation, et les capteurs à boucle de Rogowoski, comportant une bobine enroulée sur une âme non ferro-magnétique et ceinturant le conducteur parcouru par le courant à mesurer.

Les capteurs traditionnels à effet Hall ne peuvent mesurer que de faibles courants. Pour des courants plus élevés, on est obligé de neutraliser l'induction dûe au courant par un enroulement parcouru par un courant antagoniste, élaboré à partir de la mesure par le cellule de Hall elle-même, ce qui aboutit à un dispositif encombrant et cher.

Les capteurs à boucle de Rogowski présentent l'inconvénient d'être sensibles aux courants parcourant des conducteurs voisins qui peuvent exister dans une installation industrielle, et leur blindage est très difficile à réaliser.

La présente invention se propose de supprimer ces inconvénients et de réaliser un capteur de courant alternatif de construction simple et d'utilisation facile, ayant une bonne linéarité et pratiquement insensible aux courants parasites.

Le dispositif suivant l'invention comporte une bobine placée au voisinage du conducteur parcouru par le courant à mesurer et est caractérisé par un fourreau ou boîtier allongé en matière ferro-magnétique et par des moyens pour maintenir, dans une position définie à l'intérieur dudit fourreau ou boîtier, une portion dudit conducteur repliée en U et, entre les branches du U, ladite bobine.

Suivant un mode d'exécution préféré, lesdits moyens de maintien comprennent un cadre en matière isolante délimitant un compartiment central dans lequel est fixée la bobine, entouré d'un réceptacle en forme de U ouvert sur une face ou sur les côtés pour permettre l'engagement de la portion de conducteur, ledit cadre s'engageant par coulissement dans un fourreau allongé en matière ferro-magnétique.

D'autres particularités, ainsi que les avantages de l'invention, apparaîtront clairement à la lumière de la description ci-après.

Au dessin annexé:

Les figures 1 à 3 représentent un capteur de courant conforme à un premier mode d'exécution de l'invention, respectivement en coupe suivant I-I de la figure 3, suivant II-II de la figure 1 et suivant III-III de la figure 1;
les figures 4 à 6 représentent une variante, respectivement en coupe suivant IV-IV de la figure 6, suivant V-V de la figure 4 et suivant VI-VI de la figure 1;
les figures 7 à 9 illustrent un mode d'exécution dans lequel il est prévu un blindage composite et une vis de réglage de l'induction;
les figures 11 et 12 illustrent une variante, dans laquelle la vis de réglage de l'induction est perpendiculaire à l'axe de la bobine;
les figures 13 et 14 illustrent un autre mode d'exécution, dans lequel l'induction est réglée par enfoncement d'une cale magnétique; et
la figure 15 représente schématiquement l'utilisation d'un noyau plongeur pour le réglage de l'induction.

Les mêmes numéros de référence désignent des parties homologues aux diverses figures.

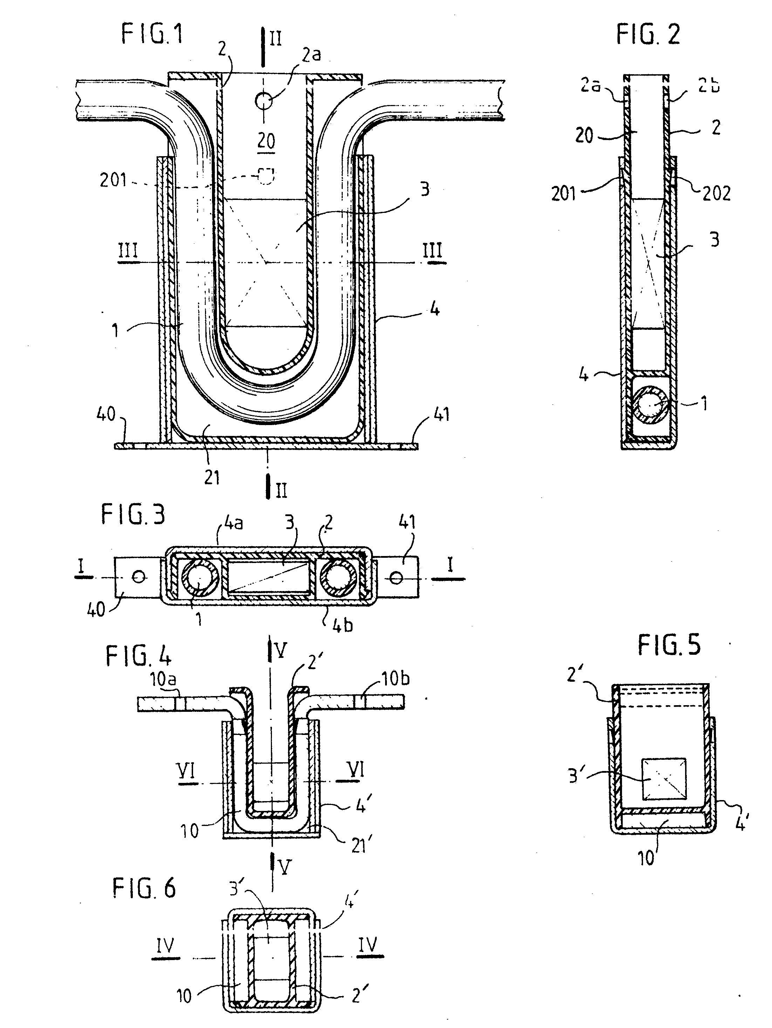

Aux figures 1 à 3, on a représenté un conducteur cylindrique souple isolé 1 ayant par exemple 16 mm$^2$ de section, parcouru par le courant à mesurer, d'intensité 50 A par exemple. Ce conducteur est replié en forme de U ayant par exemple une profondeur double de sa largeur. Le U est maintenu en forme par engagement dans un cadre 2 en matière isolante délimitant un compartiment central 20 ouvert à sa partie supérieure et de fond arrondi, entouré d'un réceptacle 21 en forme de U dont la face avant est ouverte pour permettre l'introduction de la portion repliée du conducteur. A l'intérieur du compartiment central 20 est fixée une bobine 3 dont les fils de raccordement sortent à travers deux orifices 2a—2b ménagés dans les parois principales dudit compartiment.

Le cadre 2 s'introduit par coulissement dans un fourreau 4 en matière magnétique douce obtenu par assemblage de deux demi-coquilles emboîtées l'une dans l'autre (4a—4b, figure 3). Ce fourreau est ouvert à son extrémité supérieure et muni à sa base de pattes de fixation 40—41.

Les parois principales du compartiment 20 sont munies d'ergots 201—202 qui s'engagent avec des évidements prévus dans les parois correspondantes du fourreau pour assurer le verrouillage de l'ensemble.

Les fils de la bobine sont connectés à un amplificateur opérationnel, non figuré, monté en intégrateur.

En fonctionnement, le courant qui circule dans le conducteur 1 induit dans la bobine un champ magnétique, dont l'induction, rigoureusement proportionnelle au courant, y donne naissance à une tension proportionnelle à la dérivée du courant. L'intégrateur fournit finalement un signal proportionnel au courant à mesurer. Comme la position de la bobine par rapport au conducteur est rigoureusement déterminée dans ce dispositif, le facteur de proportionnalité est constant. En outre, du fait de l'utilisation d'une bobine, il est indépendant de la température, et le courant peut avoir une fréquence quelconque.

On notera que la bobine pourra comporter un nombre de spires d'autant plus élevé que le courant à mesurer est plus faible. En ce qui concerne les courants élevés, le conducteur étant replié en U et le fourreau magnétique entourant ainsi deux positions de conducteur parcourues par des courants opposés, il ne se sature pas facilement et par conséquent, continue à jouer son rôle de blindage. On notera toutefois que, compte tenu des fuites magnétiques et de la perméabilité du fer qui constituera généralement le fourreau, celui-ci sera le siège d'une induction résiduelle maximale à mi-hauteur et nulle dans le plan de symétrie du U. Il est donc avantageux que la largeur du U ne dépasse pas une certaine limitè, qui dépend du courant à mesurer.

L'étendue de la plage de mesure n'est finalement limitée que par la section du conducteur 1.

Le dispositif peut servir à la mesure du courant par exemple dans un appareil de commutation placé dans une installation individuelle et, par conséquent, en présence de courants parcourant d'autres conducteurs voisins. En effet, le blindage le rend très peu sensible à de tels courants, ou d'ailleurs à des masses magnétiues parasites.

Dans la variante illustrée par les figures 4 à 6, le dispositif est livré à l'usager avec un élément conducteur non isolé 10 incorporé, muni de trous 10a—10b de raccordement direct aux bornes de l'appareil de commutation où circule le courant à mesurer.

Comme on le voit aux figures 5 et 6, cet élément conducteur se présente sous la forme d'une barre, ayant par exemple 20×3 mm de section pour un courant de 200 A et le cadre 2'comporte un compartiment central à l'intérieur duquel est fixée la bobine 3', entouré d'un réceptacle 21' profilé en U, ouvert sur sa face avant comme dans le mode d'exécution des figures 1 à 3. Le fourreau en matière magnétique 4' est ici de section droite sensiblement carrée.

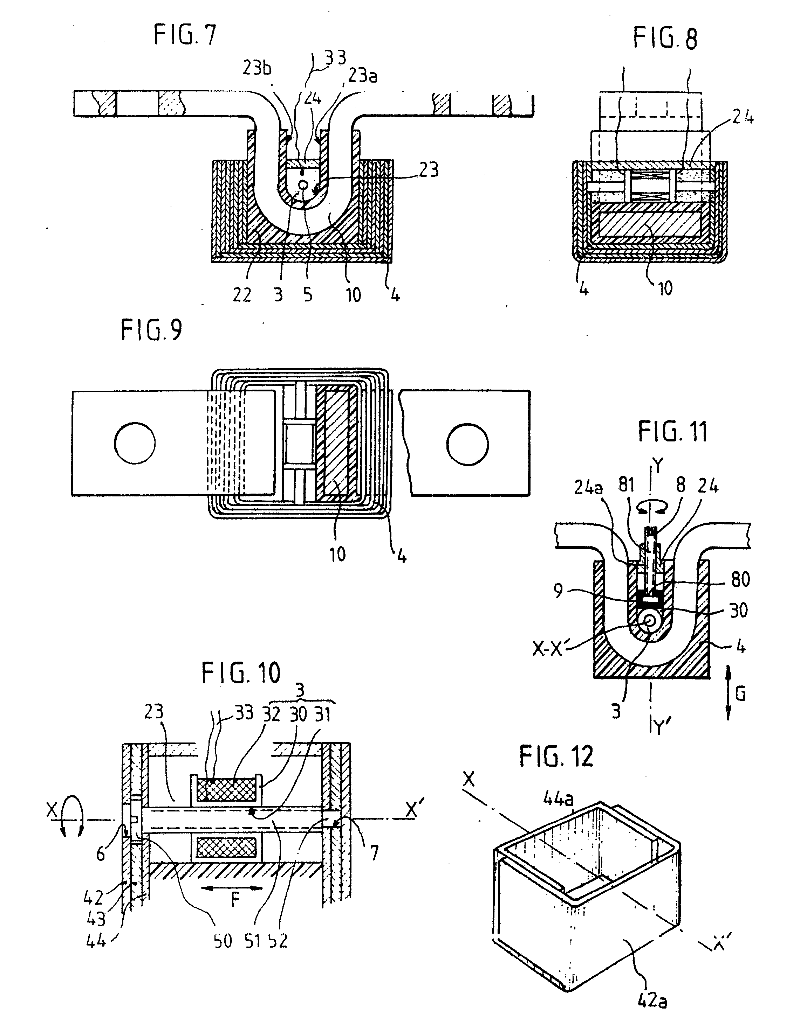

Les figures 7 à 10 illustrent différents modes d'exécution du blindage et prévoient des moyens mécaniques de réglage de l'induction.

Dans le mode d'exécution représenté aux figures 7 à 10, le fourreau 4 est constitué en deux épaisseurs, 42—44, embouties, soudées ou pliées. Ces épaisseurs sont isolées l'une de l'autre (couche 43). La couche extérieure 42 est constituée d'un matériau ferro-magnétique ordinaire, tel que le fer doux, tandis que la couche intérieure 44 est constituée par un matériau très perméable, tel que le »Mumétal«.

Pour les forts calibres (par exemple I = 400 Ampères), la couche de matériau ferro-magnétique ordinaire constituera un blindage satisfaisant. Pour les courants de faible intensité, il est préférable d'utiliser un matériau très perméable, ce qui réduit l'erreur de linéarité. Pour les courants intermédiaires, la couche très perméable risque d'être saturée des régimes transitoires (à 10 fois le courant nominal par exemple), tandis que la couche en matériau ferro-magnétique ordinaire risque de laisser passer les perturbations trop importantes provoquées par des conducteurs parcourus par un courant élevé et se trouvant à proximité du capteur. La combinaison de deux ou plusieurs couches de perméabilités différentes procure finalement un blindage satisfaisant dans une large plage de mesure et une insensibilité excellente aux perturbations.

Une vis amagnétique 5 comprend: une tête 50 pincée entre les deux couches 40 et 42 de façon à assurer son maintien axial et accessible de l'extérieur par un orifice 6; une tige filetée 51 dont l'axe XX' coïncide avec celui de la bobine 3; et un téton de centrage 52 disposé dans un palier 7 dans la face opposée du fourreau 4.

La bobine 3 comprend une carcasse 30 munie d'une ouverture filetée 31 qui coopère avec la tige 51 et un enroulement 32 muni de fils de sortie 33. La manœuvre de la vis 5 permet de déplacer la bobine dans la direction de la flèche F, ce qui permet un réglage mécanique du capteur, donc d'étalonner l'appareil.

Le cadre isolant est constitué, dans la réalisation décrite, par un réceptacle 22 surmoulé sur le conducteur 10 et par un logement de bobine 23 ayant des parois parallèles 23a—23b qui guident la carcasse pour l'empêcher de tourner. Ce logement est fermé par un couvercle 24.

Dans le mode d'exécution représenté aux figures 11 et 12 et qui conviendra à des calibres de 160 mA par exemple, le fourreau 4 est constitué de deux pièces en U 44a et 42a emboîtées l'une dans l'autre en sens inverses et respectivement constituées en »Mumétal« et en fer doux. Les ailes contiguës de ces pièces sont parallèles à l'axe XX' de la bobine et disposées symétriquement par rapport à cet axe.

Les régions de recouvrement de ces ailes, où l'épaisseur du blindage se trouve accrue, donc le phénomène de saturation reculé, sont précisément situées, par rapport au conducteur 10, dans des zones où l'induction est particulièrement élevée.

Le réglage de la position de la bobine 3, dont la carcasse 30 est contenue dans un logement isolant 23, s'effectue au moyen d'une vis 8 comportant une tête 80 et une tige filetée 81 d'axe YY' perpendiculaire à XX'. Cette tige traverse un couvercle 24 qui ferme le logement 23 et est munie d'un trou fileté 24a. La tête 80 est maintenue dans un logement 9. Sa rotation provoque le déplacement de la bobine dans la direction de la flèche G.

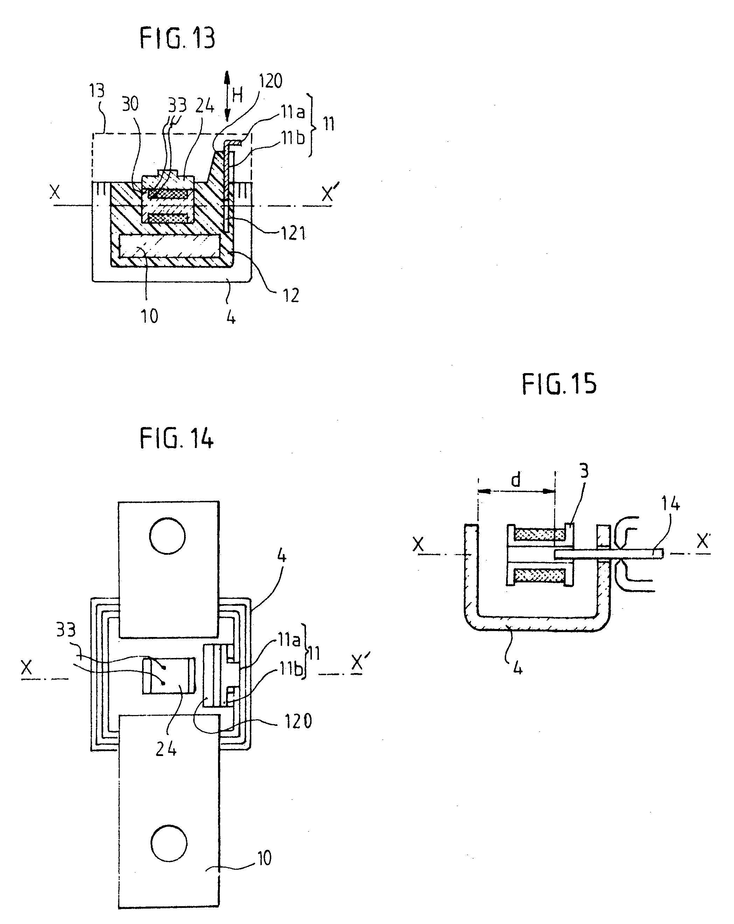

Aux figures 13 et 14, on a représenté une variante d'exécution du dispositif des figures 7 à 9, dans laquelle la vis de réglage est remplacée par une cale magnétique 11 que l'on déplace, au moyen d'un talon de manœuvre 11a, dans une rainure de guidage 121 que comporte un réceptacle 12 dans lequel est encastrée la carcasse 30 de la bobine, recouverte d'un couvercle 24. Le réceptacle 12 comporte une partie surélevée 120 qui sert à soutenir et à guider la cale 11.

Pour l'étalonnage de l'appareil, on enfonce plus ou moins la cale 11 dans la direction de la flèche H: elle isole plus ou moins la bobine de blindage 4. Après étalonnage, la cale 11 pourra être immobilisée par un surmoulage 13 de matière supplémentaire qui la recouvre.

A la figure 15, on a représenté schématiquement un petit noyau magnétique 14 qui traverse un orifice ménagé dans une paroi du blindage 4 et pénètre plus ou moins à l'intérieur de la bobine 3. Après réglage de l'entrefer d, on coupe le noyau à l'extérieur du blindage. Cette disposition procure une bonne linéarité du signal de sortie à condition que d soit relativement important, pour éviter la saturation susceptible d'apparaître lorsque les courants à surveiller sont très élevés.

Il va de soi que diverses modifications et variantes des dispositifs décrits peuvent être imaginées par l'homme du métier.

**Revendications**

1. Dispositif de mesure du courant comportant une bobine placée au voisinage du conducteur parcouru par le courant à mesurer, caractérisé par un blindage (4) en matière ferro-magnétique et par des moyens (2) pour maintenir dans une position définie, à l'intérieur dudit blindage, une portion (1) dudit conducteur repliée en U et, entre les branches du U, ladite bobine (3).

2. Dispositif selon la revendication 1, caractérisé en ce que lesdits moyens de maintien (2) sont en matière isolante et délimitent un compartiment central (20) dans lequel est fixée la bobine (3), entouré d'un réceptacle (21) dans lequel la portion de conducteur en forme de U (1) est engagée, lesdits moyens de maintien étant euxmêmes engagés dans un fourreau (4) allongé qui constitue ledit blindage.

3. Dispositif selon la revendication 2, caractérisé en ce que lesdits moyens de maintien sont constitués par un cadre (2) qui coulisse dans ledit fourreau, et par des moyens (201—202) d'encliquetage dudit cadre (2) à l'intérieur du fourreau (4).

4. Dispositif selon la revendication 1, caractérisé en ce que ledit blindage comporte au moins une couche extérieure (42) en matériau ferro-magnétique ordinaire et une couche intérieure (44) en matériau ferro-magnétique très perméable.

5. Dispositif selon la revendication 4, caractérisé en ce que les deuxdites couches (42a—44a) ont la forme de U encastrées l'une dans l'autre en sens opposés, avec recouvrement partiel des ailes parallèles à un axe de symétrie confondu avec l'axe de la bobine (XX').

6. Dispositif selon l'une des revendications 2, 4 et 5, caractérisé par un moyen mécanique de réglage de l'induction dans la bobine.

7. Dispositif selon la revendication 6, caractérisé en ce que ledit moyen de réglage est constitué par une vis amagnétique (5) agencée pour provoquer un déplacement de la bobine (3) parallèlement à son axe (XX').

8. Dispositif selon la revendication 6, caractérisé en ce que ledit moyen de réglage est constitué par une vis amagnétique (5) agencée our provoquer un déplacement de la bobine (3) suivant une direction (YY') perpendiculaire à l'axe de la bobine.

9. Dispositif selon la revendication 6, caractérisé en ce que ledit moyen de réglage est constitué par une cale magnétique (11) qui s'engage dans une rainure de guidage (121) et forme écran entre la bobine et le blindage.

10. Dispositif selon la revendication 6, caractérisé en ce que ledit moyen de réglage est constitué par un noyau magnétique (14) monté pour pénétrer plus ou moins à l'intérieur de la bobine.

**Patentansprüche**

1. Vorrichtung zur Strommessung mit einer nahe dem Leiter befindlichen Spule, in dem der zu messende Strom fließt, gekennzeichnet durch eine Abschirmung (4) aus ferromagnetischem Material und durch Mittel (2), um einen Teil des besagten, U-förmig gebogenen, Leiters in einer bestimmten Stellung und besagte Spule (3) zwischen den Schenkeln des U zu halten.

2. Vorrichtung nach Anspruch 1, dadurch gekennzeichnet, daß besagte Haltemittel (2) aus Isoliermaterial sind und einen zentralen Raum (20) abgrenzen, in dem die Spule (3) befestigt ist, wobei dieser Raum von einem Behälter (21) umschlossen ist, der den U-förmigen Teil (1) des Leiters aufnimmt und besagte Haltemittel ihrerseits von einer länglichen Hülle (4) aufgenommen werden, welche besagte Abschirmung bildet.

3. Vorrichtung nach Anspruch 2, dadurch gekennzeichnet, daß besagte Haltemittel aus einem in besagter Hülle gleitenden Rahmen (2) bestehen und aus Mitteln, um besagten Rahmen (2) im Inneren der Hülle (4) einzurasten.

4. Vorrichtung nach Anspruch 1, dadurch gekennzeichnet, daß besagte Abschirmung mindestens eine Außenschicht (42) aus gewöhnlichem ferromagnetischem Material besitzt und eine Innenschicht (44) aus stark durchlässigem ferromagnetischem Material.

5. Vorrichtung nach Anspruch 4, dadurch gekennzeichnet, daß besagte zwei Schichten (42a—44a) die Form von in Gegenrichtung verschachtelten U's haben, wobei die Schenkel, die parallel zu einer Symmetrieachse sind, welche sich mit der Spulenachse (XX') deckt, sich teilweise überdecken.

6. Vorrichtung nach einem der Ansprüche 2, 4 und 5, gekennzeichnet durch ein mechanisches Mittel zur Induktseinstellung in der Spule.

7. Vorrichtung nach Anspruch 6, dadurch gekennzeichnet, daß besagtes Einstellmittel aus einer nichtmagnetischen Schraube (5) besteht, die eine Verschiebung der Spule (3) parallel zu ihrer Achse (XX') bewirkt.

8. Vorrichtung nach Anspruch 6, dadurch gekennzeichnet, daß besagtes Einstellmittel aus einer nichtmagnetischen Schraube (5) besteht, die eine Verschiebung der Spule (3) in einer zur Spulenachse parallelen Richtung (YY') bewirkt.

9. Vorrichtung nach Anspruch 6, dadurch gekennzeichnet, daß besagtes Einstellmittel aus einem magnetischen Keil (11) besteht, der in eine Führungsrille (121) eingreift und eine Trennung zwischen der Spule und der Abschirmung bildet.

10. Vorrichtung nach Anspruch 6, dadurch gekennzeichnet, daß besagtes Einstellmittel von einem Magnetkern (14) gebildet wird, der so montiert ist, daß er mehr oder weniger ins Innere der Spule eindringen kann.

## Claims

1. A current measuring device comprising a coil placed in the vicinity of the conductor through which flows the current to be measured, characterized by a screen (4) made from ferromagnetic material and means (2) for holding in a defined position inside said screen, a portion (1) of said conductor bent into a U shape and, between the legs of the U, said coil (3).

2. The device according to claim 1, characterized in that said holding means (2) are made from an insulating material and define a central compartment (20) in which is fixed the coil (3), surrounded by a receptacle (21) in which is the U-shaped conductor portion (1) is engaged, said holding means being themselves engaged in an elongated sleeve (4) which forms said screen.

3. The device according to claim 2, characterized in that said holding means are formed by a frame (2) which slides into said sleeve and by means (201—202) for clipping said frame (2) inside the sleeve (4).

4. The device according to claim 1, characterized in that said screen comprises at least one outer layer (42) made from an ordinary ferromagnetic material and an inner layer (44) made from a very permeable ferro-magnetic material.

5. The device according to claim 4, characterized in that said two layers (42a—44a) have the shape of a U embedded in one another in opposite directions, with partial overlapping of the wings parallel to an axis of symmetry merging with the axis of the coil (XX').

6. The device according to one of claims 2, 4 and 6, characterized by a mechanical means for adjusting the induction of the coil.

7. The device according to claim 6, characterized in that said adjustment means is formed by a non-magnetic screw (5) adapted to cause movement of the coil (3) parallel to its axis (XX').

8. The device according to claim 6, characterized in that said adjustment means is formed by a non-magnetic screw (5) adapted to cause movement of the coil (3) in a direction (YY') perpendicular to the axis of the coil.

9. The device according to claim 6, characterized in that said adjustment means is formed by a magnetic wedge (11) which engages in a guide groove (121) and forms a shield between the coil and the screening.

10. The device according to claim 6, characterized in that said adjustment means is formed by a magnetic core (14) mounted so as to penetrate to a greater or lesser degree inside the coil.

FIG.1

FIG. 2

FIG.3

FIG. 4

FIG.5

FIG. 6

7

# FIG.7

# FIG.8

# FIG.9

# FIG.10

# FIG. 11

# FIG.12

## FIG. 13

## FIG. 14

## FIG. 15